Europäisches Patentamt

European Patent Office

Office européen des brevets

(11) Publication number: **0 496 365 A1**

## EUROPEAN PATENT APPLICATION

(21) Application number: **92100967.6**

(22) Date of filing: **22.01.92**

(51) Int. Cl.⁵: **H05K 3/38**, C25D 5/34, C23C 18/08, C07F 1/12

(30) Priority: **25.01.91 GB 9101655**

(43) Date of publication of application:
**29.07.92 Bulletin 92/31**

(84) Designated Contracting States:
**CH DE ES FR IT LI NL**

(71) Applicant: **AMP-AKZO CORPORATION**
**150 Motor Parkway, Suite 202**
**Hauppauge, NY 11788(US)**

(72) Inventor: **Firmstone, Michael George**

**Manor Park, The Heath**
**Runcorn, Cheshire WA7 1SP(GB)**
Inventor: **Ellwood, Michael**
**5 Greenwich Close, Bamford**
**Rochdale, Lancashire OL11 5JN(GB)**
Inventor: **Lindley, Andrew A.**
**Manor Park, The Heath**
**Runcorn, Cheshire WA7 1SP(GB)**

(74) Representative: **Königseder-Egerer, Claudia D.**
**Zugspitzstrasse 65**
**W-8104 Grainau(DE)**

(54) **Compositions for the production of seed layers.**

(57) The invention concerns fluid compositions containing gold resinate, resin binders and a vehicle which compositions are suitable for producing gold seed layers by firing on a ceramic substrate. The compositions are characterized by the inclusion of at least 1% by weight glass forming resinates and being capable of producing gold seed layers which retain high adhesion to the substrate after prolonged exposure to elevated temperatures. In a preferred embodiment the compositions also comprise resin binders comprising polymers having thermal decomposition temperatures at least 200°C above the decomposition temperature of the gold resinate.

FIG. IA

FIG. IB

FIG. 4

The present invention relates to fluid compositions for the production of seed layers which promote the adhesion of metal circuit elements to substrates.

It is known to use a seed layer of an inert metal such as gold to promote the adhesion of metal elements of a high density electrical circuit to a substrate, for example that of copper tracks to a ceramic substrate. It is also known to produce such seed layers by applying a fluid composition comprising an organogold compound, a resin derivative and a fluid vehicle to a substrate in a desired pattern, e.g., by screen printing, and then firing the coated substrate to thermally decompose the composition and produce a seed layer of gold in a corresponding pattern adhering to the substrate.

Conventional seed layers so produced tend to suffer from disadvantageous shortcomings in their physical properties. One disadvantage of such conventional seed layers is that the adhesion between the layer and the substrate tends to weaken drastically, well within the operational lifetime of the circuit, after use at typical moderately elevated operating temperatures. This effect may be so pronounced that a track and its seed layer may easily be peeled from a substrate as a cohesive whole.

Surprisingly, we have now found that it is possible to provide a composition which confers particularly good physical properties on a seed layer which is produced from it upon a substrate.

In particular such a composition is capable of producing a seed layer which does not suffer from the above disadvantageous weakening to the same extent.

Accordingly, in a first aspect the present invention provides a fluid composition for producing an essentially gold seed layer on a substrate for an electrical circuit, which comprises

a) an organogold compound,

b) an organic polymer with a thermal decomposition temperature at least 200°C higher than that of the compound (and preferably at least 250°C higher), and

c) at least 1 % w/w of the composition of a resinate glass former.

The term 'decomposition temperature' herein means the point of a relevant TGA trace at which 90% weight loss of the total organics in the material has occurred, all such TGA traces being determined under as near identical conditions as possible. (It will be appreciated that the relevant decomposition temperatures will generally be those determined in air, since the present compositions are mainly provided for air-firing applications). However, the relevant firing of the composition and substrate may in some instances be carried out in an inert atmosphere such as nitrogen. Where the decomposition temperature will tend to be higher than in air.

The term 'resinate glass former' herein means any resinate or mixture of resinates which upon firing and decomposition in air in the present composition forms a glassy inorganic oxide, mixed oxide or mixture of oxides.

The term 'gold flux' herein has its conventional meaning in the art of any trace component (other than the resinate glass former) which is conventionally used in air firing seed layer compositions for improving the finish of the product seed layer, often an oganometal compound such as a resinate. Examples of gold fluxes are given hereinafter.

In use, the composition of the present invention is applied to and fired on a substrate surface as described hereinafter.

Firing is carried out to a first temperature sufficient to decompose the gold compound, the resinate glass former and the gold flux to form free gold, the relevant inorganic glassy oxide(s), and the relevant gold flux metal or metalloid.

Firing is also carried out to a second temperature (which may or may not be the same as the first) sufficient to combine the free gold, the gold flux metal or metalloid, and the inorganic oxides, and fuse the inorganic oxides to form a glass, and so to produce a seed layer comprising gold, trace metal or metalloid and the relevant glassy oxide(s).

Air-firing compositions form a preferred class of the present compositions.

It will be appreciated that the product adherent seed layer of the firing of the composition on a substrate typically consists of an inorganic glass dispersed throughout free gold and is composed of 0.4 to 4% w/w glass and 96 to 99.6% w/w gold; the layer will also contain traces of metal from the conventional gold flux. The term 'essentially gold' herein comprises all such compositions of the seed layer.

This product seed layer has especially good adhesion to the substrate and is capable of good adhesion to any metal conventionally used for circuit conductor tracks which may be subsequently applied to it, in particular to copper or gold. Compositions specifically disclosed herein or compositions consisting of the components specifically disclosed herein have especially good properties of this type.

The molecular weight of the gold compound and/or the polymer may be sufficiently low that the relevant component is a fluid (i.e. a liquid or gel) at ambient temperatures and may then act as a fluid vehicle for the composition.

However, this is often not the case, and the composition will then additionally comprise a fluid organic vehicle.

Such a vehicle acts as a fluid matrix for the other composition components. It is especially preferred that all such composition components are mutually soluble.

Compositions in which the components are mutually soluble tend to have advantageous homogeneity.

Such homogeneity is advantageous since it tends to give rise to seed layers with the enhanced desired physical properties.

In the present composition the gold compound, polymer, resinate glass former, the gold flux and the optional vehicle should be chosen to have good mutual compatibility.

Such components should also be chosen for good compatibility with any inorganic substrate to be coated with the present composition.

The composition components specifically disclosed herein have such good mutual compatibility.

The same present gold compounds, polymers, resinate glass formers, gold fluxes and vehicles also appear to have not only the necessary compatibility with different substrate materials but to be versatile with a wide range of such materials. As described further hereinafter, one class of materials which may suitably be comprised in a substrate surface comprises ceramics, glasses or glass-ceramics.

Within the above general guidelines and those given hereinafter, suitable gold compounds, polymers, resinate glass formers, gold fluxes and optional vehicles may be established by routine trial.

The exact nature of the organogold compound within the present coating composition is immaterial providing it has a sufficiently low decomposition temperature for a polymer to fulfill the decomposition temperature criterion laid down hereinbefore, and provided it fulfills the compatibility criteria also laid down hereinbefore.

The gold compound will have a thermal decomposition temperature at least 200°C below that of the polymer, and preferably at least 250°C below. The compound suitably has a decomposition temperature in any medium in the range of 150° to 400°C, favorably in the range of 150° to 350°C.

Several suitable classes of gold compounds fulfill the above criterion and are compatible with the other composition components and the substrate materials named hereinafter.

One such class is that in which a gold moiety is bound (generally via a thio or polythio bridge) to a hydrocarbon moiety. Preferably the hydrocarbon moiety is a fairly large hydrocarbon moiety, e.g., a $C_{6-40}$ hydrocarbon, such as a $C_{6-16}$ hydrocarbon.

To enhance the desired mutual compatibility and/or solubility of the composition components, such hydrocarbons should tend to be heavily branched and/or to contain a (poly)cyclic structure. They may also be unsaturated.

From the foregoing it will be seen that one suitable sub-class of such gold compounds comprises gold (I) terpene sulphides, also known as gold terpene mercaptides.

Examples of gold terpene sulphides include gold dipentene sulphide, and in particular gold sulphides of (poly)cyclic terpenes, such as gold $\alpha$-pinene sulphide, gold camphene sulphide, and gold $\Delta^3$-carene sulphide.

This sub-class also includes the gold mercaptides of $\alpha$-thioterpineol, $\beta$-thioterpineol and thioborneol.

It will also similarly be seen that another suitable sub-class comprises alkyl mercaptides of gold, especially those where the mercapto function is attached to a tertiary carbon atom.

Such mercaptides include $C_{6-16}$ tert-alkyl or $C_{12-16}$ tert-alkyl mercaptides, e.g., gold tert-dodecyl, tetradecyl and hexadecyl mercaptides.

Such alkyl moieties will tend to exist as molecular weight cuts in which, e.g., in the dodecyl moiety the dodecyl fraction will predominate but where undecyl and tridecyl fractions will be present.

In the latter case, the predominant dodecyl fraction tends to be obtained in known preparations as a mixture of isomers, of which the 2,2,4,6,6-pentamethylhept-4-yl (2,2-bis-neopentylethyl) and 2,4,4,6-pentamethylhept-2-yl isomers are believed to predominate.

A third suitable sub-class of such gold compounds comprises aryl mercaptides of gold (I).

Preferred aryl moieties are described above for this class of hydrocarbon.

Another suitable class of such gold compounds includes gold (III) complexes with organic acid anions, such as alkanoic acid anions, and/or nitrogenous bases, such as aromatic base anions. This class comprises gold compounds such as bis(2-ethyl-4-methylimidazolyl)tetrakis(2-ethyl-hexanoato)digold (III).

A third suitable class of gold compounds includes those in which a gold (I) moiety is bound (generally directly) to a C or N atom of a heterocyclic moiety, such as pyrid-2-ylgold (I) and 1,2,4-triazolylgold (I).

Particularly useful gold compounds include gold tert-dodecyl mercaptide.

The exact nature of the polymer within the composition of the first aspect of the present invention is immaterial provided that it fulfills the decomposition temperature and compatibility criteria laid down

EP 0 496 365 A1

hereinbefore.

From the foregoing it will be appreciated that within the scope of the term "polymer" herein are included all types of homo- and co-polymers, oligomers, polycondensates and oligocondensates. A co-"polymer" may be of any type (e.g., random, block or graft). The polymer may be cross-linkable, cross-linked or neither, and may contain curing agents.

As with the gold compound, the polymer will seldom be a pure compound, but will often consist of a mixture of congeners.

The polymer will have a thermal decomposition temperature at least 200°C above that of the organogold compound, and preferably at least 250°C above, in the same ambient medium, which may vary with the medium.

The polymer suitably has a decomposition temperature in any medium in the range of 350° to 1000°C, favorably in the range of 400° to 550°C.

One suitable class of polymers which fulfills the above criterion and consists of materials compatible with the other composition components and the substrate materials named herein includes homopolymers of the following and mutual copolymers and copolymers thereof with aromatic vinylics such as styrene, e.g., dienes, such as butadiene, isoprene and 1,5-cyclooctadiene; colophony and rosin; and asphalts, such as Gilsonite.

Useful polymers include polydienes such as poly(butadiene).

Particularly useful polymers include copolymers of these dienes with 1,5-cyclooctadiene, butadiene-acrylonitrile copolymers, and copolymers with acrylics and in particular with styrene.

Poly(butadienes) and butadiene-styrene copolymers, such as the Cariflex series (Shell), are among preferred polymers.

Another suitable class of polymers includes polyaromatics such as polyphenylene. A further suitable class is believed to include high melting or decomposition polyamides including aromatic polyamides, and polyimides.

A yet further suitable class is believed to include other polymers containing a polyaromatic backbone interrupted by ether, ketone and/or sulphone linkages, such as PEEK, PEK and PES supplied by ICI.

An additional class is believed to include synthetic resins, such as thermosetting epoxy resins (e.g., the reaction product of epichlorhydrin and bisphenol A, together with curing agents) and acrylic resins.

The range of decomposition temperatures relative to the (known) decomposition temperatures of suitable organogold compounds and the processing conditions described hereinafter will clearly tend to indicate to the skilled man further suitable and preferred polymers.

The polymer will often also be chosen for its ability (together with any vehicle) to confer a viscosity on the composition which is suitable for application to the substrate in a desired (retained) pattern, e.g., by screen printing.

Adjustment of the composition viscosity may also be achieved by the inclusion of conventional thickeners and thixotropes (as described further below). If only the main polymer is used to adjust the viscosity, this property will conventionally tend to be determined by the average molecular weight of the polymer, in a manner known to the skilled man.

The seed layer composition, when used for screen printing, will suitably have a viscosity in the range of 20 to 2000 ps, preferably 200 to 1000 ps at 2.5 rpm.

For many types of these materials, it is preferred that the polymer is soluble in any vehicle present and/or the organogold compound (or vice versa). For these reasons, preferred polymers tend to be non-crosslinked.

All the forgoing polymers belong to known classes of materials.

Most of the polymers mentioned hereinbefore may be used alone as a composition component or as mixtures. A mixture of homologues is often used for convenience in adjusting the rheology of the composition.

The exact nature of the glass former resinate within the present composition is immaterial providing it is capable of fulfilling the glass-forming criterion laid down hereinbefore, and provided it fulfills the compatibility criteria also laid down hereinbefore.

Like the organogold compound, it may have a thermal decomposition temperature at least 200°C below that of the polymer, e.g., at least 250°C below.

The glass former resinate suitably has a decomposition temperature in any medium in the range of 150° to 400°C, favourably in the range of 150° to 350°C.

The glass former resinate will often be a mixture of at least one metal resinate with at least one metalloid resinate. The metal, or each metal, will often be selected from Groups 1A to 4A, 2B to 7B and 8 of the Periodic Table, in particular from Groups 3A, 4A and 2B to 5B. The metaloid, or each metalloid, will

4

often be selected from Groups 2A to 6A, in particular Groups 2A to 5A.

The glass former resinate will preferably be a mixture of at least two materials selected from at least two of the following categories a) to c):

a) organometallic compounds of metals such as lead, cadmium, zinc, magnesium and tin;

b) boron resinates; and

c) silicon resinates.

Such materials in a) may be compounds of the relevant metal with the type of organic moiety described hereinbefore for the gold compound.

Such materials may also be compounds with rosin (e.g., the reaction product of the relevant metal oxide with rosin). Where the substrate for the seed layer is aluminium nitride (as referred to hereinafter), it is preferred that the present composition contains a zinc glass former.

It will be seen that suitable materials in this preferred class will form glasses on fusion which will include respectively borate, silicate and borosilicate glass containing dissolved metal oxide(s).

The glass formed on fusion will generally be amorphous; however, whether or not the oxides combine in the crystalline or amorphous state will depend on the glass former resinate chosen.

The rheological parameters of the composition will vary in a manner evident to the skilled man with the amount of any fluid present in the composition.

These parameters will hence vary with any optional organic vehicle which is present. The vehicle will usually be present in the composition of the present invention and is often a mixture of organic liquids. The vehicle will often be chosen to impart specific physical properties to the composition. These properties, such as oiliness, viscosity, evaporation rate, surface tension, and tack will vary for different methods of application.

The requisite properties and the vehicle required to produce them will be well known to those skilled in the art of inks and paints.

Any such vehicle will often be chemically inert, and should preferably be of low toxicity.

A fairly high boiling point or mixture of boiling points for the vehicle will tend to be desirable and significant in controlling the necessary removal of the vehicle from the composition on a substrate during the early stages of any firing process. Boiling points in the range 150° to 250°C are preferred.

Suitable vehicles include the following and compatible mixtures thereof:

aromatics, such as xylene and high boiling petroleum fractions, e.g., Aromasol H (ICI);

substituted aromatics, such as nitrobenzene and o-nitrotoluene;

aliphatics and essential oils, such as high-boiling petroleum fractions, terpenes, e.g., $\alpha$- and $\beta$-pinene, dipentene and dipentene oxide, and rosemary, lavender, fennel, sassafras, wintergreen and aniseed oils and camphor and turpentine;

alcohols and alcohol mixtures such as isodecanol, butyl carbitol (Union Carbide), terpene alcohols, such as terpineol, $\alpha,\beta$-terpineol and cineol, and Cellosolve (Union Carbide);

esters and ester mixtures, such as butyl carbitol acetate (Union Carbide), butyl oxalate, dibutyl phthalate, dibutyl benzoate and butyl Cellosolve acetate (Union Carbide).

Preferred vehicles or vehicle components include $\alpha$-terpineol, butyl carbitol and Aromasol H.

However, vehicles comprising any of the foregoing materials may not adequately dissolve all the other composition components.

It may be necessary for improved solution of the compounds and/or polymer to include other vehicle components which, although good solvents, are not favored since they have relatively low boiling points.

Examples of such low boiling vehicles include chlorinated solvents such as dicholoromethane, chloroform and carbon tetrachloride, ketones such as methyl ethyl ketone, esters such as ethyl, butyl and amyl acetates, alcohols such as isopropanol and butanol, aromatics such as toluene, and low boiling petroleum ethers, such as $C_{3-6}$ cut.

In the compositions of the present invention the proportions of gold compound to polymer, resinate glass former and the golf flux and to optional vehicle may vary.

These proportions may be optimised by routine trial to give desired physical properties of the composition.

Such desired properties may be, e.g., good coating and/or cohesive behavior of the product seed layer, e.g., the structure and surface properties of the gold and the glass within the layer.

The proportions of the gold compound in the composition may be 20 to 50%, e.g., 25 to 30% w/w.

Typically the gold compound will contain 15 to 55%, e.g., 25 to 55% w/w gold, which will all be released on the thermal decomposition. The proportions of gold in the composition may thus be 8 to 25%, e.g., 16 to 20% w/w.

The proportion of polymer may be 1 to 55%, preferably 5 to 20% w/w, and that of the vehicle up to 50% w/w.

It will be understood that the optimum ratios of the concentrations of gold compound and polymer to that of the glass former resinate in the present composition will vary with the glass former resinate system selected.

The glass former resinate will be present as at least 1% w/w of the seed layer composition. However, the proportion of the glass former resinate in the composition may often be 2.5 to 12.5%, e.g., 3 to 7.5 w/w.

Where the glass former resinate is a mixture of resinates, the proportions of the component resinates within the glass former resinate may vary widely with the component resinates selected. However, by way of example the preferred resinate glass formers described hereinbefore may comprise 25 to 65% w/w metal resinates, 5 to 70% w/w silicon resinate and/or 5 to 65% boron resinate.

Where only two component resinates are present, they may be present as 55 to 85% w/w metal resinate, 5 to 45% w/w silicon resinate and/or 5 to 45% w/w boron resinate. Where three component resinates are present, they may be present as 25 to 65% w/w metal resinate, 10 to 50% w/w silicon resinate and/or 5 to 45% w/w boron resinate.

Within the above ranges the dispersibility in the vehicle of the polymer, resinate glass former and/or the gold compound should be sufficient for them to be dispersed adequately and evenly.

This parameter will clearly indicate to the skilled many preferred proportions for given materials.

The present composition is generally provided for air-firing applications and will thus generally contain other components which are conventional in air-firing seed layer compositions, such as traces of materials other than the resinate glass former to improve the finish of the seed layer (included in the so-called golf fluxes).

Typical gold fluxes which may be present may include:

bismuth flux (e.g., the so-called bismuth carboxylate, or the reaction product or bismuth subnitrate and rosin), generally at up to 7% w/w;

rhodium flux or resinate (e.g., the so-called rhodium carboxylate, or the resinate, i.e., the reaction product of rhodium chloride and terpene sulphide) generally at up to 2% w/w;

chromium flux (e.g., as diketonate complex), generally at up to 1%;

copper, cobalt, antimony, and vanadium fluxes (e.g., the reaction product of the relevant metal oxide with rosin), each generally at up to 11 w/w; and

silver, palladium and platinum fluxes, generally at less than 0.1% w/w.

The flux(es) used will depend to some extent on the substrate (as is conventional). Where the substrate for the seed layer is aluminum nitride (as referred to hereinafter), it is preferred that the present composition contain a bismuth flux.

Rhodium flux is particularly advantageous as a component of the gold flux.

The present compositions may contain other conventional components, such as

thixotropes or viscosifying agents, such as cellulose acetate butyrate, nitrocellulose, Perchem XT (Perchem) and Thixatrol ST (NL Industries), generally at up to 10% w/w;

anti-tack additives, such as white petroleum jelly and white mineral oil, dioctyl phthalate, safflower oil and silicon oil (generally at up to 10%);

flow aids, such as silicons or acrylics (e.g., Modaflow, Multiflow (Monsanto)), generally at up to 5% w/w; and visualisation aids, such as solvent soluble dyes, e.g., Dispersol Red 4G-PC and Navy 5R-PC (ICI) (generally at up to 0.1% w/w).

In a second aspect the present invention provides a process for the production of a composition of the present invention, comprising intimately mixing an organogold compound, a polymer and resinate glass former as hereinbefore defined, and optionally an organic fluid vehicle.

As described further in the Examples below, the mixing step may be carried out by conventionally blending the components, for example by stirring, high-shear mixing, or mixing using a planetary vacuum mixer, or (for less mutually soluble components) by milling, e.g., using a ball-mill or multi-roll mill.

It may be helpful to apply some heat in such mixing.

In general, suitable temperatures may vary over a range below that which is deleterious to any component, or evaporates it, but will typically be in the range of 15° to 65°C; for example, ambient temperature are known to be suitable.

Process times are typically in the range of 1 to 20 minutes.

The substrates for use in the invention may have any suitable form, and may have a wide variety of shapes and sizes. For example, they may be of the form described below in the specific description of the seed layer production process.

The substrate surface to which the present composition is applied may suitably be a ceramic, a glass or a glass-ceramic material which softens at a temperature higher than that of the firing temperature of the composition or of any fired component (e.g., an air-firing dielectric insulator) subsequently applied.

Where the substrate is a ceramic it is preferably one selected from the group consisting of beryllia, alumina, zirconia, silica, aluminum nitride, silicon carbide, silicon nitride, strontium nitride, barium titanate, barium tetratitanate and barium zircotitanate.

Suitable glasses include respectively high-melting barium and lead borosilicate and aluminosilicate and other barium glasses and high-melting glass containing dissolved metal oxides.

Suitable glass-ceramics include silicate glasses containing dispersed particulate ceramics as listed above.

The substrate may also suitably be a coating of one or more such materials on a ceramic sheet, for example to a thickness in the range of 1 to 500 micron.

Suitable sheet ceramics include those ceramics listed above.

Other mixtures of all the foregoing materials may be used.

The substrate may also suitably be a coating of one or more such materials on a metal sheet, for example to a thickness in the range of 1 to 500 micron.

Suitable sheet metals include iron, cobalt, nickel, titanium and copper and alloys thereof, including stainless steels and low carbon steels.

Where the organogold compound and the glass former resinate in the seed layer composition are of the preferred (low decomposition temperature) types described below, and all the other components have a similarly low decomposition temperature, the substrate may be a low melting glass, such as a soda glass.

The seed layer produced by firing a composition of the present invention on a substrate surface of any conventional material referred to above appears to bind well to such surface.

This is surprising in the case of substrate surfaces comprising aluminum nitride.

Seed layers formed from conventional gold resinates not specifically adapted for aluminum nitride which have been fired under conventional conditions and then plated with copper tracks do not adhere well to aluminum nitride substrate surfaces unless these have been, e.g., oxidatively pre-treated.

Compositions comprising the preferred resinate glass formers (in particular of zinc) referred to hereinbefore and/or which include a bismuth resinate give rise to seed layers with good AlN adhesion.

The preparation of the compounds and composition of the present invention is described in the following Description and Examples, respectively.

Description - Preparation of Gold tert.-Dodecyl Mercaptide

Diethyl sulphide (4.0 ml, 38 mmole) was added dropwise with stirring to a solution of hydrogen tetrachloroaurate (III) trihydrate (5.0 g, 2.7 mmole) in methanol (100 ml). Stirring was continued at room temperature until complete declorisation of the gold solution had occurred (10 min).

Tert.-Dodecyl mercaptan (2.82 g, 14 mmole) was added dropwise to the mixture with stirring at room temperature. The resultant white suspension was stirred for a further 2 hr., and then allowed to settle. The methanol was decanted, and the resultant viscous white oil was dissolved in chloroform (30 ml), and the solution was added dropwise to vigorously stirred methanol (250 ml). The supernatant methanol was decanted, and residual solvent was removed under vacuum at 40°C, giving a viscous water white oil. Yield, 5.03 g, 96% on Au.

| Analysis: $C_{12}H_{25}SAu$ | | | | |
|---|---|---|---|---|
| requires | C 36.1, | H 6.3, | S 9.0, | Au 49.5 |
| found | C 35.5, | H 6.5, | S 11.0, | Au 47.6 |

nmr ($CDCl_3$) delta      0.90 (s), 1.25 (sm, br), 1.45 (s), 1.70 (sm, br)

Example - Preparation of Seed Layer Precursor Compositions

Compositions of the following formulations were prepared by simple mixing, dissolving all the glass former and gold flux resinates, dye and flow aid in dichloromethane, filtering, adding the organic vehicle and evaporating off the dichloromethane.

The gold resinate followed by the polymer were mixed in by hand, followed by thorough mechanical mixing. The gold resinate was that prepared in the above Description.

7

| Percentage w/w of total composition | | | | |
|---|---|---|---|---|
| Composition No. | 1 | 2 | 3 | 4 |
| Component | | | | |
| Gold resinate D.1 | 30.20 | 26.19 | 30.19 | 26.19 |
| Gold fluxes | 2.41 | 2.09 | 0.04 | 0.03 |
| Glass former | 1.87 | 4.93 | 5.33 | 7.95 |
| Aromasol | 41.30 | 41.87 | 41.30 | 43.78 |
| Terpineol 318 | 13.72 | 14.08 | 13.40 | 13.60 |
| Cariflex BR1202E | 9.32 | 9.60 | 8.52 | 7.39 |
| Ethyl cellulose T200 | 1.17 | 1.23 | 1.05 | 0.95 |
| Dispersol Red dye 4G-PC | 0.001 | 0.001 | 0.05 | 0.05 |
| Tego flow ZFS 460 | 0.004 | 0.003 | 0.11 | 0.10 |

| Percentage w/w of total composition | | | |
|---|---|---|---|
| Composition No. | 5 | 6 | 7 |
| Component | | | |
| Gold resinate D.1 | 32.04 | 32.04 | 32.04 |
| Gold fluxes | 2.57 | 2.57 | - |
| Glass former | 8.40 | 3.71 | 3.6 |
| Aromasol | 35.75 | 38.62 | 40.04 |
| Terpineol 318 | 11.85 | 12.83 | 13.32 |
| Cariflex BR1202E | 8.12 | 8.86 | 9.24 |
| Ethyl cellulose T200 | 1.01 | 1.11 | 1.16 |
| Dispersol Red dye 4G-PC | 0.06 | 0.06 | 0.04 |
| Tego flow ZFS 460 | 0.20 | 0.20 | 0.12 |

| Composition No. Component | 1 | 2 | 3 | 4 |
|---|---|---|---|---|
| Gold resinate % w/w of composition | 13.9 | 12.1 | 13.9 | 12.1 |
| Glass former pph on Au | | | | |
| Pb | 1.1 | 3.36 | 1.1 | 3.36 |
| B | 0.06 | 0.19 | 0.60 | 0.19 |
| Si | 0.28 | 0.86 | 1.28 | 1.86 |
| Mg | – | – | 1.0 | 1.0 |
| Zn | – | – | 1.0 | 1.0 |
| Gold Flux pph on Au | | | | |
| Bi | 1.5 | 1.5 | – | – |
| Rh | 0.5 | 0.5 | 0.3 | 0.3 |
| Cr | 0.14 | 0.14 | 0.15 | 0.15 |
| Sn | 0.04 | 0.04 | – | – |
| Pd | 0.017 | 0.017 | – | – |
| Ag | 0.016 | 0.016 | – | – |
| Pt | 0.003 | 0.003 | – | – |

| Composition No. | 5 | 6 | 7 |
|---|---|---|---|
| Component | | | |
| Gold resinate % w/w of composition | 15.0 | 15.0 | 15.0 |
| Glass former pph on Au | | | |
| Pb | 11.34 | 0.8 | - |
| B | - | 0.16 | 0.16 |
| Si | 2.0 | 0.32 | 0.32 |
| Mg | - | - | - |
| Zn | - | - | 0.6 |
| Gold Flux pph on Au | | | |
| Bi | 1.5 | 1.5 | - |
| Rh | 0.5 | 0.5 | 0.5 |
| Cr | 0.14 | 0.14 | - |
| Sn | 0.04 | 0.04 | - |
| Pd | 0.017 | 0.017 | - |
| Ag | 0.016 | 0.016 | - |
| Pt | 0.003 | 0.003 | - |

In a third aspect the present invention provides a process for producing an essentially gold seed layer on a substrate, characterised by applying a layer of a composition of the present invention to the substrate and firing the coated substrate so as to convert the composition to essentially gold.

(It will be appreciated that the produced adherent seed layer of the firing of the composition on a substrate typically consists of an inorganic glass dispersed throughout free gold and is composed of 0.4 to 4% w/w glass and 96 to 99.6% w/w gold; the layer will generally also contain traces of metal from the above-mentioned gold fluxes. The term 'essentially gold' herein comprises all such compositions of the seed layer.)

In a fourth aspect the present invention provides a seed layer on a substrate produced by the process of the third aspect of the invention.

It will be appreciated that the substrate in the present invention may be a single layer, so that the seed layer is the seed layer for a single-layer circuit. It may also be a substrate layer in a multilayer circuit, and it may thus have been produced by firing a dielectric composition over a circuit layer on a previous substrate layer.

The process of the third aspect of the present invention thus relates to the production both of a seed layer in a single-layer circuit and of a seed layer in the top circuit layer of successive stages of a multilayer circuit. Such a latter circuit layer will thus be subsequently covered with a dielectric composition which will be fired to give the substrate for the next circuit layer.

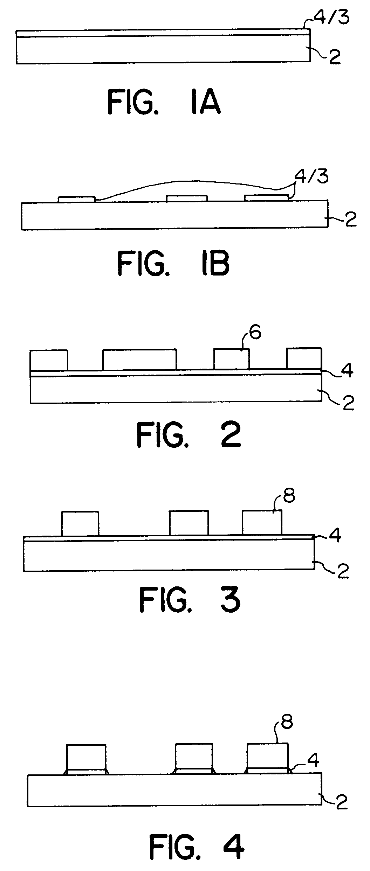

The process of the third aspect of the invention and the product of the fourth aspect will now be described with reference to the attached drawings, in which Figures 1 to 4 are sections through an electrical circuit comprising the seed layer, at different stages of production.

As shown in Figures 1a and 1b, the substrate 2, onto which a gold seed layer 4 is introduced, is typically of a high temperature and/or refractory material as described further hereinbefore, e.g., 96% pure alumina in the form of a flat rectangular plate, optionally with through-holes, cut-outs and/or via posts, e.g., a 100mm x 100mm square plate, 0.5 to 1mm thick.

As shown in Figures 1a and b, a gold seed layer 4 is introduced and bonded onto the surface of the substrate 2 by deposition onto the substrate 2 of a fluid precursor composition of the seed layer 4.

The first step in the process of the third aspect of the present invention may involve conventional cleansing of the relevant surfaces of the substrate.

A layer 3 of the composition on the substrate 2 is formed by a conventional printing, coating or other transfer method.

Deposition of the fluid precursor composition sufficient to give a final seed layer 4 at a loading of 0.1 to 2 $mg/cm^2$ is suitable for most purposes.

The final thickness of the seed layer may be important since if it is too thin it will not conduct sufficiently for subsequent electroplating. However, it is not essential that all the precursor composition for the desired final loading of the product seed layer be laid down in one step, since in all cases the coating and firing steps to produce the seed layer may be repeated as often as is desired, or gold may be otherwise added to build up the seed layer further.

A suitable loading of precursor composition layer 3 (generally within the range of 0.4 to 30 $mg/cm^2$) to give the abovementioned loading of seed layer 4 may readily be determined by the skilled man by routine trial and without undue experimentation.

In a first embodiment, shown in Figure 1a, the precursor is applied as a continuous layer 3 covering the substrate 2 throughout, e.g., by screen printing, spraying, curtain or roller coating, or transfer application, and converted to a continuous-sheet gold layer 4.

This layer 4 will be subsequently removed in part after the conductor tracks 8 have been applied to it to produce a seed layer under and corresponding to the desired final circuit conductor track pattern 8.

In a second embodiment, shown in Figure 1b, a gold seed layer 4 is laid down generally corresponding to the final conductor track pattern.

In one variant of this second embodiment, the precursor is applied in any desired pattern 3, e.g., by screen printing or decal or transfer application, usually corresponding to the desired final circuit pattern.

In a second variant the precursor is applied as a continuous layer 3 covering the substrate 2 throughout as in embodiment 1a, e.g., by screen printing, spraying, curtain or roller coating, or transfer application, and converted to a continuous-sheet gold layer 4. This layer 4 is subsequently removed in part before the conductor tracks 8 are applied to it to produce the patterned seed layer 4 corresponding to the desired final circuit conductor track pattern 8.

These two embodiments are of course two extreme cases; the process may often be a combination of features of both.

For example, the seed layer precursor 3 will be laid down and the seed layer 4 produced in a pattern corresponding to the final track pattern of that circuit layer with extra areas to provide electrical continuity over the whole pattern.

Such continuity may be needed for convenience in the subsequent plating of the tracks 8 onto the seed layer 4, but not in the final circuit layer.

In such a case, the surplus areas will be removed to give a seed layer pattern corresponding essentially to the circuit conductor track pattern.

Once the layer 3 of seed layer composition has been applied in either process embodiment, the coated substrate 2 is then fired conventionally at 400° to 1000°C so that the organogold compound in the precursor seed layer 3 decomposes to release the gold, the resinate glass former decomposes to form the relevant inorganic glass-forming oxide(s), the polymer (optionally cures) and burns off, the free gold and the inorganic oxides combine, and the inorganic oxides fuse to form a glass.

This firing produces a solid cohesive seed layer 4 comprising gold and the relevant oxide glass, suitably at a loading on the substrate of 0.1 to 2$mg/cm^2$ for most purposes.

The product adherent seed layer 4 of the firing of the composition on a substrate typically consists of an inorganic glass dispersed throughout free gold and is composed of 0.4 to 4% w/w glass and 96 to 99.6% w/w gold.

The firing is preferably carried out at towards 900°C, optionally first applying a dwell tie at about 500°C.

As noted hereinbefore some of the present seed layer compositions may produce a seed layer 4 at lower temperatures (e.g., in the range of 500° to 700°C).

Such compositions may be suitable for use on lower melting or softening substrates. Suitable temperatures and heating profiles in such cases will be apparent to the skilled man.

Some of the fired substrates (known to the skilled man) are then allowed to cool through natural radiation (e.g., 1 to 4 hours to 100° to 300°C), when they are removed from the furnace.

The final thickness of the seed layer may be important since if it is too thin it will not conduct sufficiently for subsequent electroplating.

The loading given above is suitable for most purposes. However, in all cases the coating and firing steps may be repeated as often as is desired to build up the seed layer further.

Additional gold may also be added to the seed layer by electroplating (e.g., using a conventional gold citrate plating bath) or by electroless methods analogous to those which may be used to apply, e.g., copper or gold tracks to the seed layer and described hereinafter. The substrate may subsequently be refired to 500° to 700°C to improve the adhesion of the resultant plated gold film to the substrate.

In the second variant of the second embodiment (Figure 1b), the sheet gold seed layer 4 is then coated with light-hardening or solubilising electrical resist 5 (not shown). The resist 5 is exposed to a light pattern corresponding to the gold track pattern or a negative of the pattern.

The unhardened or solubilised parts of the resist 5 are then selectively dissolved with a conventional fluid to expose the seed layer 4 underneath selectively, defined by a resist corresponding to the desired pattern.

The seed layer 4 surface uncovered by the resist 5 is then attacked with an appropriate solvent for the seed layer.

Suitable solvents include aromatic sulphonate/cyanide solution, e.g., Superstrip 100 (Lea Ronal), potassium iodide/iodine solution, or Entreat 100 (Engelhard), to remove all of the continuous seed layer 4 not covered by the resist 5.

The removal results in essentially the same product as in the first variant of the second embodiment.

In both embodiments, referring to Figures 3 and 4, a conductor pattern 8 of a suitable metal (as mentioned hereinbefore), preferably copper or gold, is then formed on the seed layer.

The conductor pattern 8 may conveniently be formed in situ, for example by plating a pattern seed layer 4 shown in Figure 1a, or by masking and plating of the sheet seed layer 4 shown in Figure 1b, although the ex situ formation of a solid pattern 8 and its application to the seed layer 4 is not excluded.

In in situ formation of the conductor pattern 8 in both present embodiments, the seed layer 4 is then electroplated with solid copper to a thickness and width at all points well in excess of the thickness of the seed layer 4, for example 3 to 75 micron, in particular 5 to 20 micron, and in the desired conductor pattern 8.

As described further hereinafter, similar gold tracks may alternatively be added to the seed layer by electroplating (e.g., using a conventional gold citrate plating bath) or by electroless plating.

Figure 2 shows the first step in the plating part of the process applied to the Figure 1a embodiment.

In this embodiment the sheet gold layer 4 is first coated with light-hardening or solubilising electrical resist 6 generally to a thickness in the range of from 3 to 75 micron.

In any event the resist should preferably be at least as thick as the intended thickness of the subsequently applied metal (e.g., copper or gold) tracks.

The resist 6 is exposed to a light pattern corresponding respectively to a negative of a desired conductor pattern or the pattern itself. The unhardened or solubilised parts of the resist 6 are then selectively dissolved with a conventional fluid (see also the description above of a similar process in relation to Figure 2).

This exposes the seed layer 4 underneath selectively, defined by a resist corresponding to a negative of the desired pattern.

After such partial removal of the resist 6 the product is conventionally electroplated or electrolessly plated.

In the first (Figure 1a) present embodiment, the conductor pattern 8 may also be applied to the sheet seed layer 4 by other conventional means, such as by applying a fluid precursor pattern, e.g., by screen printing or decal or transfer application, which is then converted to the desired solid conductor pattern 8.

However, in all cases, electroplated conductor patterns 8 are generally and advantageously denser and have better strength properties, primarily due to the increased cohesiveness of the layer so applied, compared with, e.g., screen printed conductor patterns 8.

In a process modification, high definition tracks are produced by masking the plating, followed by a repeat of these steps to produce broader tracks or areas for connections, e.g., by substrate through holes.

In the second (Figure 1b) present embodiment the desired plating pattern is already provided by the seed layer 4 pattern, and therefore does not require the foregoing resist processing steps.

That is, the seed layer 4 shown in Figure 1b may be plated directly, or (less usually) the conductor pattern may be applied as above.

The result of the plating process (or other process for applying the conductor pattern 8) and any necessary removal of a resist, if (as shown in Figures 3 and 4) a thick conductor pattern 8 is built up on a thin seed layer 4, the latter respectively is a continuous sheet or in a pattern corresponding to the conductor pattern.

In the first embodiment of the invention the seed layer 4 surface not covered by and adhering to the conductor pattern 8 is then attacked with an appropriate solvent for the seed layer gold, such as aromatic sulphonate/cyanide solution (Superstrip 100 (Lea Ronal)), potassium iodide/iodine solution, or Entreat 100 (Engelhard). The solvent removes all of the continuous seed layer 4 not covered by the conductor pattern 8, resulting in essentially the same product as that of the direct plating in the second embodiment.

As noted hereinbefore, in an alternative, gold tracks may be plated onto a gold seed layer.

The skilled man will appreciate that the first embodiment of the process may still be used, but that it may be necessary to protect the gold tracks 8 conventionally in any removal of the gold seed layer 4 as described immediately above.

In a further modification of the described method (not shown), the seed layer 4 is applied in a pattern of (usually rectangular) windows in an otherwise generally continuous layer.

A thick film resistor composition is then conventionally applied across each window (e.g., by screen printing) to overlap the seed layer at a pair of opposing sides and is fired to form a resistor.

The conductor tracks 8 are then applied as described hereinbefore. The skilled man will appreciate that it may be necessary to protect the resistor conventionally during any such plating process. This modification gives improved track terminals to the resistors.

As noted hereinbefore, the circuit produced by the present invention may be a circuit layer in a multilayer circuit.

Such a circuit layer will thus be subsequently covered with a dielectric composition which will be fired to give a substrate for the next circuit layer.

In one modification of the circuit (not shown) in Figure 1b, a copper pattern is coated at least on its upper surface with a film.

The film is of a metal which will inhibit the diffusion of oxygen into, and oxidation of, the conductor pattern during any firing in the present process which may (typically) be carried out in air. This film may be nickel, palladium, gold, silver, chromium, rhodium, or any alloy thereof.

The film is particularly useful in areas where the (oxidisable) copper is exposed to air, e.g., in through holes between adjacent layers in a multilayer circuit.

In yet a further modification (not shown), the film is coated with a thin film of copper to be oxidised and act as an adhesion layer between the film and a second (fired dielectric substrate) is applied in the present process.

Test Examples

Copper conductors in a single layer circuit were laid down as described above on seed layers applied by the process of the present invention on 96% pure alumina, using the following seed layer compositions.

The copper conductors were subjected to a modified version of the pull peel test method described in the Du Pont test bulletin A-74672. The modification used was to dip solder the 2mm x 2mm copper pads described in the bulletin and to hand solder individual wires to each pad, rather than to rows of pads.

The conductors were tested as formed initially and after accelerated aging at 150°C, 165°C and/or 175°C for 1000 hr. In the case of aging at 150°C, the wires were soldered to the pads before aging; at 165°C and 175°C, the conductors were aged and mechanically cleaned, and then the wires were soldered to the pads. The following results were obtained, fracture occurring in the substrate or at the seed layer - substrate interface in all cases.

## Yield stress, Kg

| Compo-sition | 150°C | | 165°C | | 175° | |
|---|---|---|---|---|---|---|
| | Initial | 1000 hr | 500 hr | 1000 hr | 500 hr | 1000 hr |
| 1 | 7.4 | 5.5 | 7.4 | 2.0 | 4.0 | 3.0 |
| 2 | 7.7 | 5.6 | 7.1 | 5.2 | 7.5 | 4.4 |
| 3 | 5.9 | 5.9 | 6.3 | 3.5 | 2.3 | 1.7 |
| 4 | 7.0 | 6.0 | 6.8 | 1.9 | 5.1 | 1.6 |
| 5 | 4.8 | | 0.8 | | 1.6 | |
| 6 | 5.6 | | 2.7 | | 4.6 | |

The values at 500 and 1000 hr and many of the initial values for the seed layers from the present compositions were found to be substantially better than for seed layers from conventional compositions.

The above procedure was repeated for Composition 7 on aluminium nitride (Keramont 7C) with the following test results:

## Yield stress, Kg
### 150°C

| | Initial | 16 hr | 500 hr |
|---|---|---|---|
| Composition 7 | 0.7 | 1.1 | 1.4 |

The plated seed layers from the same composition were also tested in the butt pull test, with the following results:

## Yield stress, Kg
### 150°C

| | Initial | 16 hr | 500 hr |
|---|---|---|---|
| Composition 7 | 5.0 | 6.6 | 9.1 |

## Claims

1. A fluid composition comprising an organogold compound, a resin derivative and a fluid vehicle, which composition when applied to a substrate and fired thereon, thermally decomposes and produces an essentially gold seed layer on said substrate suitable for producing an electrical circuit, said gold seed layer being capable of maintaining adhesion to said substrate after 500 hours at 175°C, that is at least 30% of the initial adhesion, the improvement comprising the composition comprising at least 1% by weight of a resinate glass former added thereto, said resinate glass former being any resinate or mixture of resinates which, upon firing in air, forms a glassy inorganic oxide, mixed oxide or mixture of oxide.

2. The fluid composition of claim 1 further comprising an organic polymer having a thermal decomposition temperature at least 200°C higher than that of the organogold compound, said thermal decomposition temperature being the temperature at which 90& weight loss has occurred in a thermal gravimetric analysis of the organic polymer.

3. The fluid composition of claims 1 or 2 wherein the resinate glass former comprises at least one metal resinate and at least one metalloid resinate, said metal resinate containing a metal selected from Groups 1A to 4A, 2B to 7B and 8 of the Period Table and mixtures thereof, and said metalloid resinate containing a metalloid selected from the Groups 2A to 6A of the Periodic Table and mixtures thereof.

4. The fluid composition of claim 3 wherein the resinate glass former comprises at least one metal resinate having a metal selected from Groups 3A, 4A and 2B to 5B of the Periodic Table and mixtures thereof, and at least one metalloid resinate having a metalloid selected from the Groups 2A to 5A of the Periodic Table and mixtures thereof.

5. The fluid composition of claims 1 or 2 wherein the resinate glass former comprises a mixture of at least two material selected from the groups consisting of organometallic compounds of metals selected from the group consisting of lead, cadmium, zinc, magnesium, tin, and mixtures thereof, boron resinates, and silicon resinates.

6. The fluid composition of claim 3 wherein the resinate glass former comprises a mixture of 25% to 65% resinates of metals selected from the group consisting of lead, cadmium, zinc, magnesium, tin, and mixtures thereof, and 75% to 35% resinates selected from the group consisting of boron resinates, and silicon resinates, and mixtures thereof.

7. The fluid composition of claims 1 or 2 wherein the substrate is aluminum nitride, the resinate glass former comprises a zinc glass former, and the seed layer is capable of increasing the adhesion of the seed layer to the substrate after long term exposure to elevated temperatures.

8. The fluid composition of claim 1 wherein the organic polymer has a thermal decomposition temperature at least 250°C higher than that of the organogold compound.

9. The fluid composition of claims 1 or 2 wherein the organic polymer if selected from the group consisting of homopolymers and copolymers of dienes, rosin and asphalts, copolymers thereof with aromatic vinyl monomers, polyaromatics, polymers having a polyaromatic backbone interrupted by ether, ketone and sulfone linkages, epoxy resins and acrylic resins and mixtures thereof.

10. The fluid composition of claim 9 wherein the organic polymer comprises homopolymers and copolymers of dienes selected from the group consisting of poly(butadiene), copolymers of dienes with 1,5-cyclooctadiene, butadiene-acrylonitrile copolymers, butadiene-acrylonitrile-styrene copolymers and butadiene-styrene copolymers.

11. A ceramic substrate having thereon a gold seed layer formed by coating the substrate with the fluid composition according to claims 1 or 2; and firing the coated substrate to produce a solid cohesive seed layer comprising gold and the oxide glass.

12. The ceramic substrate of claim 11 wherein a conductive pattern is formed on the substrate by plating metal on the seed layer.

FIG. IA

FIG. IB

FIG. 2

FIG. 3

FIG. 4

## DOCUMENTS CONSIDERED TO BE RELEVANT

EP 92100967.6

| Category | Citation of document with indication, where appropriate, of relevant passages | Relevant to claim | CLASSIFICATION OF THE APPLICATION (Int. Cl.5) |
|---|---|---|---|
| A | EP - A - 0 394 987 (AMP/AKZO) * Claim 1; example 3 * -- | 1,5,6 | H 05 K 3/38 C 25 D 5/34 C 23 C 18/08 C 07 F 1/12 |
| A | EP - A - 0 394 977 (AMP/AKZO) * Claims 1,19 * -- | 1,5,6 | |
| P,A | US - A - 5 059 242 (FIRMSTONE et al.) * Claims; example 3 * -- | 1,5,6 | |
| A | US - A - 3 619 287 (STANKAVICH) * Claims 1,2 * ---- | 1,5,6 | |

TECHNICAL FIELDS
SEARCHED (Int. Cl.5)

C 07 F
C 23 C
C 25 D
H 05 K

The present search report has been drawn up for all claims

| Place of search | Date of completion of the search | Examiner |
|---|---|---|
| VIENNA | 23-04-1992 | LUX |

EPO FORM 1503 03.82 (P0401)